# EUROPEAN PATENT APPLICATION

(11) **EP 4 528 711 A1**
(43) Date of publication of application: **26.03.2025**
(21) Application number: 24199989.5
(22) Date of filing: 12.09.2024
(51) Int. Cl.: G10H 1/00, G10H 1/12

(54) **IMPEDANCE CONVERSION DEVICE AND SIGNAL PROCESSING APPARATUS**

(30) Priority: 22.09.2023 JP 2023158367
(71) Applicant: Yamaha Corporation, Hamamatsu-shi, Shizuoka 430-8650 (JP)
(72) Inventor: NAKAMURA, Yoshihiro, Hamamatsu-shi, Shizuoka-Ken, 430-8650 (JP); TSUGE, Yoshiyuki, Hamamatsu-shi, Shizuoka-Ken, 430-8650 (JP); MIYAKE, Yoshiro, Hamamatsu-shi, Shizuoka-Ken, 430-8650 (JP); NORO, Masao, Hamamatsu-shi, Shizuoka-Ken, 430-8650 (JP); SASAKI, Yu, Hamamatsu-shi, Shizuoka-Ken, 430-8650 (JP)
(74) Representative: Hoffmann Eitle

(57) **Abstract**

An impedance conversion device includes: a first input terminal to which a first analog signal output from an electric musical instrument is input; a splitter configured to split the first analog signal into a second analog signal and a third analog signal; a first output terminal from which the second analog signal is output; an impedance conversion circuit configured to convert an impedance of the third analog signal; and a second output terminal from which an analog signal obtained by converting the impedance is output. An input impedance of the impedance conversion circuit is approximately 1 GQ or more.

## Description

### CROSS REFERENCE TO RELATED APPLICATION

This Application is based on, and claims priority from, Japanese Patent Application No. 2023-158367, filed on September 22, 2023, the entire contents of which are incorporated herein by reference.

### TECHNICAL FIELD

The present disclosure relates to impedance conversion devices and signal processing apparatuses.

### BACKGROUND

Analog signals produced by playing an electric musical instrument such as an electric guitar or an electric bass guitar are amplified and emitted as sound via a connected guitar amplifier and speaker. In recent years, there has been a desire to digitally refine analog music sound post playing. For example, analog signals output from electric musical instruments may be digitally recorded and refined using a DAW (Digital Audio Workstation) run on a personal computer. The refined sound is then emitted via an amplifier and speaker and monitored in a studio or the like.

Use of such a technique requires attention to the following points. An analog signal output from an electric musical instrument generally is of high impedance, whereas an input of a device for converting the analog signal to a digital signal is of low impedance. As a consequence, when an electric musical instrument is directly connected to an analog-to-digital (A/D) converter, problems occur such as noise or deformation of a signal waveform due to impedance mismatch.

To mitigate such problems, a preamplifier circuit or the like is used to convert an impedance of an analog signal output from an electric musical instrument, and the analog signal with the changed impedance is supplied to the A/D converter. Known in the art as such a preamplifier circuit is, for example, the technique disclosed in Japanese Patent Application Laid-Open Publication No. 2018-180478 (hereafter, JP 2018-180478).

### SUMMARY

The technique disclosed in JP 2018-180478 is subject to a drawback, however, in that an impedance of an analog signal output from an electric musical instrument cannot be converted for supply to an A/D converter, while sound of the electric musical instrument is amplified and emitted via a connected guitar amplifier and a speaker.

An impedance conversion device according to an aspect of the present disclosure includes: a first input terminal configured to input a first analog signal output from an electric musical instrument; a splitter configured to split the first analog signal into a second analog signal and a third analog signal; a first output terminal configured to output the second analog signal; an impedance conversion circuit configured to convert an impedance of the third analog signal; and a second output terminal configured to output the converted third analog signal from the impedance conversion circuit. An input impedance of the impedance conversion circuit is approximately 1 GΩ or more.

### BRIEF DESCRIPTION OF THE DRAWINGS

Fig. 1 is a block diagram showing a signal processing apparatus including an impedance conversion device according to an embodiment.
Fig. 2 is a diagram showing an example of an impedance conversion circuit.
Fig. 3 is a diagram explaining corrections of characteristics of A/D conversion in the signal processing apparatus.
Fig. 4 is a diagram explaining corrections of characteristics of D/A conversion in the signal processing apparatus.
Fig. 5 is a diagram showing corrections of phase characteristics relative to frequencies.
Fig. 6 is a diagram showing corrections of amplitude characteristics relative to frequencies.
Fig. 7 is a diagram showing an example connection of the signal processing apparatus.
Fig. 8 is a diagram showing an example connection of the signal processing apparatus.

### DETAILED DESCRIPTION

An impedance conversion device according to an embodiment of the present disclosure will be described below with reference to the accompanying drawings. The description in the following embodiment includes technically preferable configurations. However, such configurations are not limitative of the scope of the disclosure of the invention unless otherwise specifically stated in the following description.

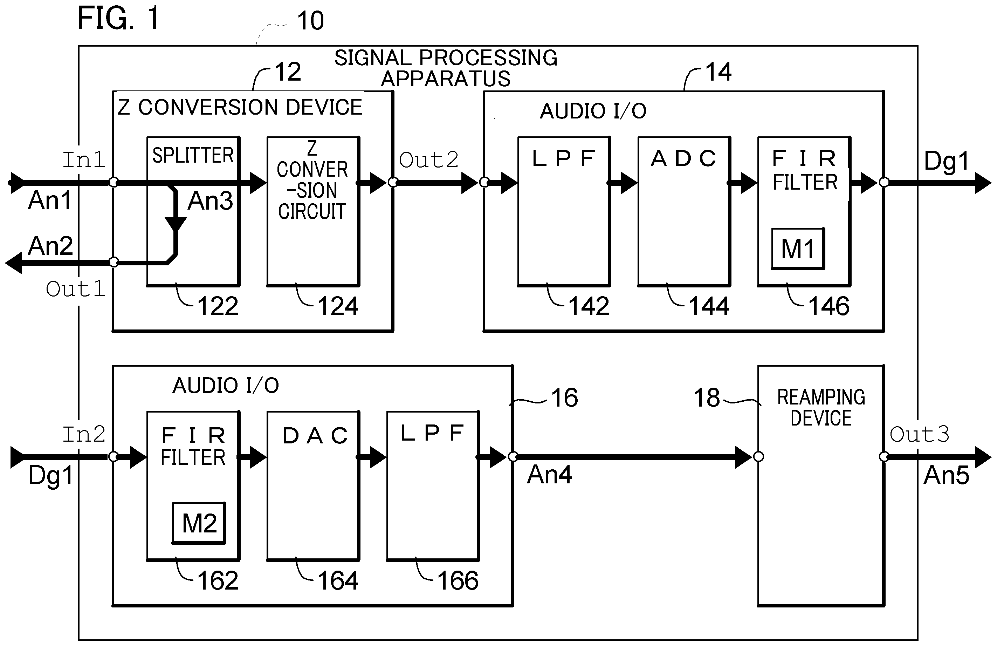

Fig. 1 is a block diagram showing a configuration of a signal processing apparatus 10 including an impedance conversion device 12 according to this embodiment. The signal processing apparatus 10 includes an audio I/O (Input/Output) 14, 16 and a reamping device 18 in addition to the impedance conversion device 12. In the drawings, impedance is denoted as "Z."

The impedance conversion device 12 includes an input terminal In1, an output terminal Out1, an output terminal Out2, a splitter 122, and an impedance conversion circuit 124.

The splitter 122 splits a high-impedance analog signal An1 supplied to the input terminal In1, into an analog signal An2 and an analog signal An3. The analog signal An1 is a signal output from an electric musical instrument. The electric musical instrument is equipped with one or more elements that sense and convert vibration of sound into an electric signal. The impedance of the analog signal An1 is, for example, from around 200 kS2 to 500 kS2.

Of the split analog signals An2 and An3, the analog signal An2 is output from the output terminal Out1, and the analog signal An3 is supplied to the impedance conversion circuit 124. The impedance conversion circuit 124 converts the high-impedance analog signal An3 into a signal of lower impedance than that of the analog signal An1. An example configuration will be described later. The analog signal An3, which has been converted into a low-impedance signal, is output from the output terminal Out2.

An audio I/O 14 is a device that converts the analog signal An3, which has been converted into a low-impedance signal, into a digital signal. The audio I/O 14 includes a LPF (Low Pass Filter) 142, an ADC (Analog to Digital Converter) 144, and a FIR (Finite Impulse Response) filter 146.

The LPF 142 is an analog filter that cuts high frequency components of the analog signal An3, which has been converted into a low-impedance signal. Specifically, the LPF 142 cuts high frequency components of the analog signal An3 prior to digitization to prevent incorporation of DC components. The ADC 144 converts the analog signal An3, which has had high frequency components cut by the LPF 142, into a digital signal. The FIR filter 146 is a digital filter for imparting characteristics (described later) to digital signals output from the ADC 144. Information such as coefficients that define characteristics to be imparted by the FIR filter 146 is stored by an acquirer 148 (described later) in a storage device M1 included in the FIR filter 146. In other words, the characteristics to be imparted by the FIR filter 146 are defined by the information stored in the storage device M1. The digital signals output from the FIR filter 146 are denoted as Dg1. The characteristics to be imparted by the FIR filter 146 comprise an example of a "first characteristic."

The audio I/O 16 is a device that converts digital signals into analog signals. The audio I/O 16 includes a FIR filter 162, a DAC (Digital to Analog Converter) 164, and a LPF 166.

The FIR filter 162 is a digital filter for imparting characteristics (described later) to digital signals Dg1 that are input to the input terminal In2. Information such as coefficients that define the characteristics to be imparted by the FIR filter 162 is stored 162 by an acquirer 168 (described later), in a storage device M2 included in the FIR filter 162. In other words, the characteristics to be imparted by the FIR filter 162 are defined by the information stored in the storage M2. The characteristics to be imparted by the FIR filter 162 comprise an example of a "second characteristic."

The DAC 164 converts digital signals output from the FIR filter 162 into analog signals. The LPF 166 is an analog filter that smoothes analog signals output from the DAC 164. Analog signals output from the LPF 166 are denoted as An4.

The reamping device 18 converts low-impedance analog signals An4 output by the LPF 166 into high-impedance signals, and outputs the converted high-impedance analog signals from the output terminal Out3. The reamping device 18 is a device that receives input of low-impedance analog signals An4 and supplies high-impedance analog signals to a guitar amplifier, as described later. The high-impedance analog signals output from the output terminal Out3 are denoted as An5.

The analog signal An1 is an example of a "first analog signal"; the analog signal An2 is an example of a "second analog signal"; the analog signal An3 is an example of a "third analog signal," and the analog signal An4 is an example of a "fourth analog signal." The input terminal In1 is an example of a "first input terminal"; the input terminal In2 is an example of a "second input terminal"; the output terminal Out1 is an example of a "first output terminal"; the output terminal Out2 is an example of a "second output terminal," and the output terminal Out3 is an example of a "third output terminal." The audio I/O 14 is an example of a "first input/output device," and the audio I/O 16 is an example of a "second input/output device." The ADC 144 is an example of an "A/D converter," and DAC 164 is an example of a "D/A converter." The FIR filter 146 is an example of a "first characteristic imparter," and the FIR filter 162 is an example of a "second characteristic imparter."

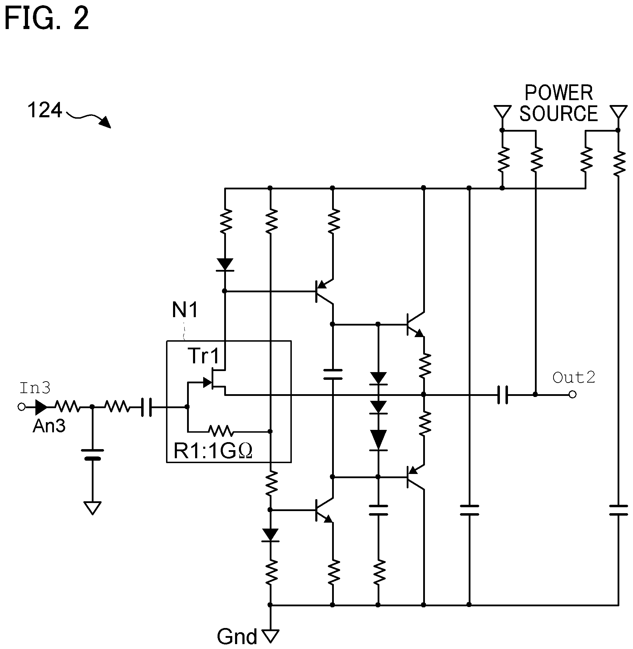

Fig. 2 is a circuit diagram showing an example of an impedance conversion circuit 124 of the impedance conversion device 12. The analog signal An3 split by the splitter 122 is supplied to the input terminal In3 of the impedance conversion circuit 124. Only AC components of the analog signal An3, are supplied to an input section N1. The input section N1 has a transistor An3 for inputting the AC components of the analog signal An3 to a gate, and a resistive element R1 for bringing the AC components of the analog signal Tr1 to a midpoint potential of a power supply. The transistor Tr1 is, for example, an N-channel type JFET (Junction Field Effect Transistor). The power source (high level) is applied to the drain of the transistor Tr1, and a signal at the source of the transistor Tr1 is amplified and output from the output terminal Out2. In this embodiment, the resistance of the resistive element R1 is 1 GS2. Therefore, in the impedance conversion circuit 124, the DC impedance of the input terminal In3 is 1 GS2.

When the analog signal An1 is split into the analog signals An2 and An3 at the upstream splitter 122, the DC impedance of the input terminal In3, into which one of the split signals is supplied, is extremely high, namely 1 GS2. Therefore, the impedance of the analog signal An2, which is the other of the split signals, remains unchanged from the impedance of the analog signal An1, and is output from the output terminal Out1 with close to the same impedance being maintained. The analog signal An3 split from the analog signal An1 and supplied to the input terminal In3 is converted into a low impedance signal by the impedance conversion circuit 124, and is output from the output terminal Out2.

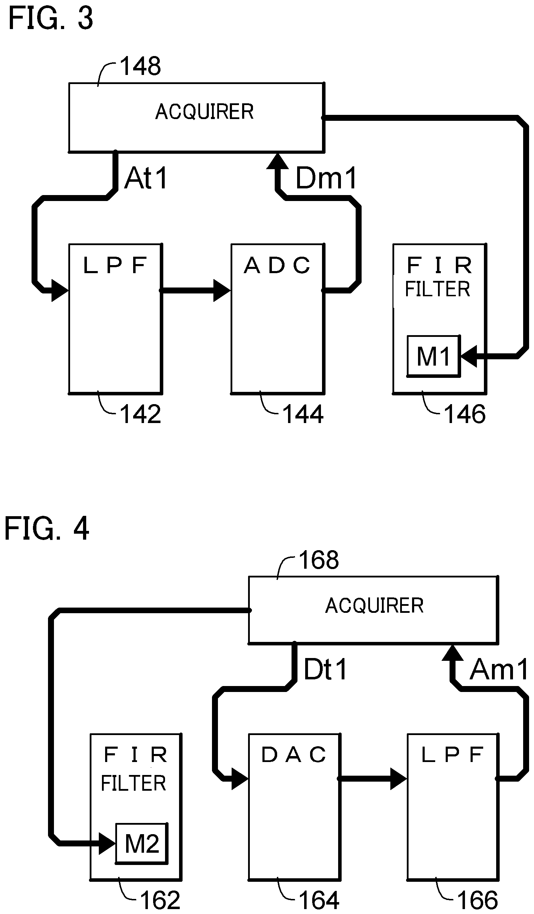

Fig. 3 is a diagram showing a configuration for determining characteristics to be imparted by the FIR filter 146. The frequency characteristics of the LPF 142, which is an analog filter, ideally are flat, but in reality are not flat. Furthermore, when the ADC 144 processes analog signals before conversion, the analog signals may vary dependent on frequency. On the other hand, it is desirable that the digital signal Dg1 output from the audio I/O 14 is a signal obtained by faithfully digitizing the analog signal An1. Therefore, in the configuration according to this embodiment, variations in frequency characteristics of the analog signal from the out terminal Out2 that occur under processing by the LPF 142 and the ADC 144 are cancelled by the FIR filter 146 before being output as the digital signal Dg1.

In this embodiment, examples of the frequency characteristics include frequency phase characteristics indicating changes in phase depending on the frequency, and frequency amplitude characteristics indicating changes in amplitude depending on the frequency. Characteristics of the FIR filter 146 are determined with the input terminal of the LPF 142 decoupled from the output terminal Out2 of the impedance conversion device 12. The output of the ADC 144 is also decoupled from the input of the FIR filter 146.

The acquirer (an example of a "characteristic acquirer") 148 obtains frequency characteristics in the path from the LPF 142 to the ADC 144, and stores information defining inverse characteristics of the obtained frequency characteristics in the storage device M1 of the FIR filter 146.

Specifically, the acquirer 148 supplies an analog test signal At1 to the input terminal of the LPF 142, and receives a digital signal Dm1 from the output terminal of the ADC 144. The analog test signal At1 is, for example, a signal obtained by converting into an analog signal, a digital source signal with frequencies swept over an audible range from 20 Hz to 20 kHz and with uniform amplitudes. When the test signal At1 is filtered at the LPF 142 and converted by the ADC 144 into the digital signal Dm1, the digital signal Dm1 is a signal with the frequency characteristics at the LPF 142 and the ADC 144 imparted to the analog test signal At1. The acquirer 148 compares the digital signal Dm1 with the digital source signal of the analog test signal At1 to obtain frequency phase characteristics and frequency amplitude characteristics for the digital signal Dm1 that correspond to a difference from those of the source signal. The acquirer 148 stores information defining the inverse characteristics of the obtained frequency phase characteristics and frequency amplitude characteristics in the storage device M1 of the FIR filter 146. Thus, the FIR filter 146 is set to have frequency characteristics defined by the stored information. The acquirer 148 is preferably circuitry included within the signal processing apparatus 10, but is not limited thereto, and the acquirer 148 may be a device external to the signal processing apparatus 10. The external device may be used as a test device during manufacture of the signal processing apparatus 10.

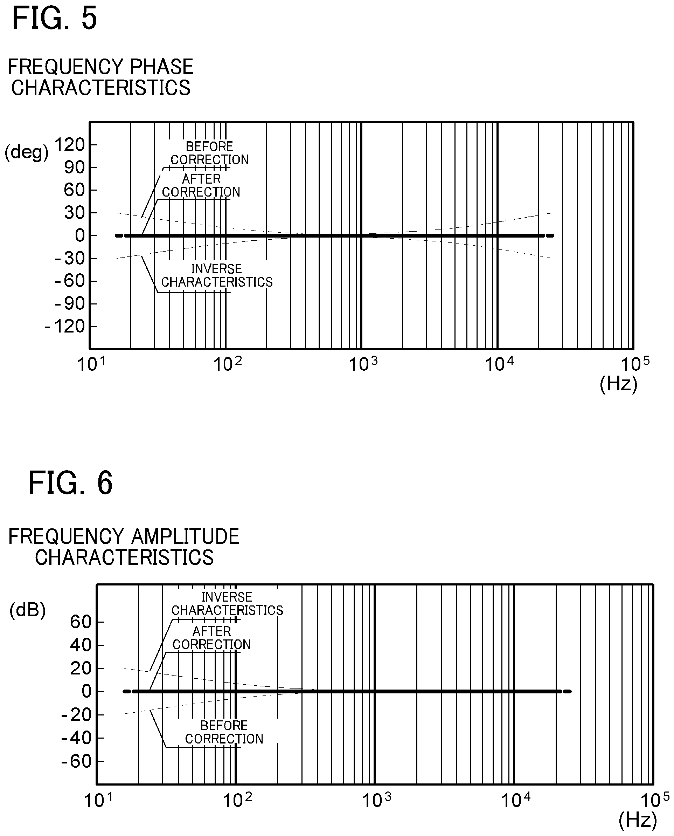

Fig. 5 is a diagram illustrating corrections of frequency phase characteristics at the FIR filter 146. In Fig. 5, when the digital signal Dm1 is obtained as a result of the test signal At1 passing through the LPF 142 and being converted into the digital signal Dm1 by the ADC 144, "before correction" refers to a difference in phase characteristics between the digital source signal of the test signal At1 and the digital signal Dm1. "Inverse characteristics" refer to characteristics obtained by inverting the phase characteristics before correction relative to reference characteristics of 0 degrees. "After correction" refers to frequency phase characteristics obtained by imparting the inverse characteristics to the frequency phase characteristics as of before correction. As shown, after correction, the frequency phase characteristics are generally flat in an audible band.

Fig. 6 is a diagram illustrating corrections of frequency amplitude characteristics in the FIR filter 146. In Fig. 6, when the digital signal Dm1 is obtained as a result of the test signal At1 passing through the LPF 142 and being converted into the digital signal Dm1 by the ADC 144, "before correction" refers to a difference in amplitude characteristics between the digital source signal of the test signal At1 and the digital signal Dm1. "Inverse characteristics" refer to characteristics obtained by inverting the amplitude characteristics before correction relative to reference characteristics of 0 db. "After correction" refers to frequency amplitude characteristics obtained by imparting the inverse characteristics to the frequency amplitude characteristics before correction. As shown, after correction, the amplitude characteristics are generally flat in the audible band.

Fig. 4 is a diagram showing a configuration for determining characteristics to be imparted by the FIR filter 162. In the DAC 164, when converting digital signals into analog signals, resultant analog signals may vary depending on frequency. As with the LPF 142, the frequency characteristics of the LPF 166, which is an analog filter, ideally are flat, but in reality are not flat. On the other hand, it is sometimes desirable that an analog signal An4 output from the audio I/O 16 is a signal obtained by faithfully analogizing the digital signal Dg1. Therefore, in the configuration according to this embodiment, variations in frequency characteristics of the digital signal Dg1 that occur under processing in the DAC 164 and the LPF 166 are cancelled using the FIR filter 162 before being output as the analog signal An4.

The characteristics of the FIR filter 162 are determined, with the input terminal of the DAC 164 decoupled from the output terminal of the FIR filter 162 and the output terminal of the DAC 166 decoupled from the input terminal of the reamping device 18.

The acquirer (an example of a "characteristic acquirer") 168 supplies a digital test signal Dt1 to an input terminal of the DAC 164, receives an analog signal Am1 from an output terminal of the LPF 166, and converts the analog signal Am 1 into a digital signal. The digital test signal Dt1 is, for example, a digital source signal with frequencies swept over the audible range and with uniform amplitudes. When the digital test signal Dt1 is converted into an analog signal by the DAC 164 and filtered at the LPF 166, the filtered signal Am1 is a signal with the frequency characteristics at the DAC 164 and the LPF 166 imparted to the digital test signal Dt1. The acquirer 168 converts the analog signal Am1 into a digital signal, and compares the converted digital signal with the digital test signal Dt1. Then, the acquirer 168 obtains frequency phase characteristics of the converted digital signal relative to the digital signal Dm1 and frequency amplitude characteristics of the converted digital signal relative to the digital signal Dm1. The acquirer 168 stores information defining the inverse characteristics of the obtained frequency phase characteristics and frequency amplitude characteristics in the storage device M2 of the FIR filter 162. Thus, the FIR filter 162 is set to have frequency characteristics defined by the stored information. The acquirer 168 is preferably circuitry provided within the signal processing apparatus 10. However, it is not limited thereto. The acquirer 168 may be an external device of the signal processing apparatus 10. The external device may be used as a test device in a manufacture process of the signal processing apparatus 10.

Although not shown in the figures, when the filter coefficient specifying the inverse characteristics has been set in the FIR filter 162, the digital signal Dg1 supplied to the input terminal In2 is converted into an analog signal An4 with close to flat frequency phase characteristics and close to flat frequency amplitude characteristics.

Next, an example use of the signal processing apparatus 10 according to this embodiment will be explained.

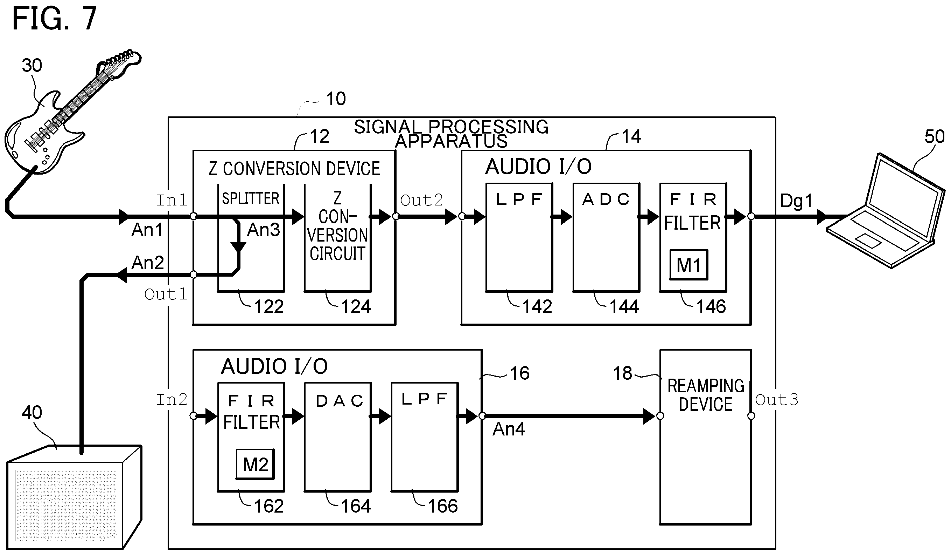

Fig. 7 is a diagram showing an example connection to the signal processing apparatus 10. In the example shown, a signal from an electric guitar 30 is supplied to the input terminal In1 of the impedance conversion device 12 as an analog signal An1. A combination guitar amplifier 40 is connected to the output terminal Out1, and a digital signal Dg1 is recorded in a personal computer 50. The combination guitar amplifier 40 amplifies analog signals and emits sound via its built-in speaker.

Specifically, a signal that is output when the user plays the electric guitar 30 is amplified and emitted by the combination guitar amplifier 40. That is, when the user plays the electric guitar 30 the user is able to listen to sound amplified by and emitted from the combination guitar amplifier 40. Electric musical instruments such as an electric guitar 30 can be played without connection to the combination guitar amplifier 40, but with minimal sound and expression, as various playing techniques specific to electric musical instruments can only be expressed when connected to the combination guitar amplifier 40. To realize and monitor sound and expressivity when playing an electric musical instrument, in this case the electric guitar 30, it is necessary for the electric musical instrument to be connected to the combination guitar amplifier 40. Close monitoring is important for recording a piece of music for use on a CD (Compact Disk) or the like. The electric guitar 30 is an example of an "electric musical instrument."

Generally, humans can recognize a distinction between two sounds in an audible band if there is difference in loudness of 0.1 dB or greater in the same frequency range. If a DC impedance at the input terminal In3 of the impedance conversion circuit 124 is 1 GS2, a difference in loudness between the analog signal An1 and the analog signal An2 can be made less than 0.1 dB when the analog signal An1 is split into the analog signal An2 and the analog signal An3 at the splitter 122. Therefore, in this embodiment, the signal processing apparatus 10 is interposed between the electric guitar 30 and the combination guitar amplifier 40, with almost negligible influence of the signal processing apparatus 10 as compared with a case in which the electric guitar 30 and the combination guitar amplifier 40 are directly connected.

Thus, if the DC impedance in the impedance conversion circuit 124 is approximately 1 GS2 or more, a difference in loudness between the analog signal An1 and the analog signal An2 is suppressed to less than 0.1 dB. That is, the DC impedance of approximately 1 GS2 or more means that the difference between the analog signal An1 and the analog signal An2 is so small as to be imperceptible to humans.

Furthermore, when signals output by playing the electric guitar 30 are amplified and emitted by the combination guitar amplifier 40, the signals may be recorded for later playback or further refining. In this embodiment, the analog signal An3 split at the splitter 122 is converted into a low impedance signal by the impedance conversion circuit 124, is further converted into a digital signal Dg1 by the audio I/O 14, and is recorded in the personal computer 50.

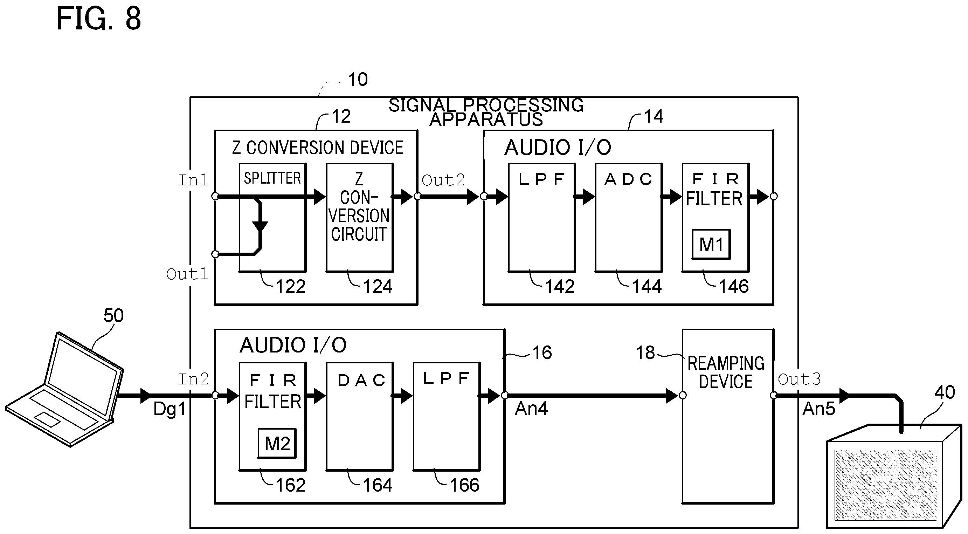

Fig. 8 is a diagram showing another example connection to the signal processing apparatus 10. In this example connection, a digital signal Dg1 recorded by the personal computer 50 is supplied to the input terminal In2 of the audio I/O 16, converted into an analog signal by the audio I/O 16, and amplified and emitted by the combination guitar amplifier 40 connected to the output terminal Out3, i.e., this is an example of a playback.

As shown in Fig. 7, an analog signal An1 produced by the playing of the electric guitar 30 is split into an analog signal An2 and an analog signal An3. The analog signal An2 is emitted from the combination guitar amplifier 40 with little change from the analog signal An1. The analog signal An3 is converted into a digital signal Dg1 by the audio I/O 14 and recorded in the personal computer 50. In the audio I/O 14, changes in frequency characteristics caused by processing at the LPF 142 and the ADC 144 are cancelled by the FIR filter 146. Therefore, the analog signal An1 can be converted into a dry digital signal Dg1 with little deterioration (with no effects). As shown in Fig. 8, the digital signal Dg1 recorded in the personal computer 50 is converted into an analog signal by the audio I/O 16, further converted into a high-impedance signal by the reamping device 18, and emitted from the combination guitar amplifier 40. In the audio I/O 16, changes in frequency characteristics caused by the DAC 164 and the LPF 166 are cancelled by the FIR filter 164. As result, the digital signal Dg1 can be faithfully converted to an analog signal. Therefore, in the present embodiment, playback sound output from the combination guitar amplifier 40 as shown in Fig. 8 can be reproduced to almost match the played sound output from the combination guitar amplifier 40 as shown in Fig. 7.

The embodiment described above can be variously modified. Specific variations that may be applied to embodiments are exemplified below. Two or more modes freely selected from the following examples may be combined in so far as they do not contradict each other.

Since the digital signal Dg1 recorded in the personal computer 50 is dry with a little deterioration, amplifier characteristics can be readily imparted to the digital signal Dg1 by executing an amplifier simulator of a DAW (Digital Audio Workstation) or the like in the personal computer 50. Furthermore, by processing the digital signal Dg1 in the audio I/O 16, it is possible to impart amplifier characteristics.

Impedance conversion circuits are generally used to convert high impedance analog signals to low impedance signals, but may also be used for refining, given properties of the circuit. The impedance conversion circuit 124 in the above embodiment does not have such properties, but the digital signal Dg1 recorded is a dry signal without deterioration. Therefore, by imparting to the digital signal Dg1 characteristics desired by the user using a DAW or the like, it is possible to variously enhance sounds during refining.

In the embodiment, the electric guitar 30 is given as an example of an electric musical instrument, but it is not limited thereto. Aside from the electric guitar 30, a Hammond ^{™} organ or a bass guitar are other such examples of an electric musical instrument that sense and convert vibration of a sounding body into an electric signal. Further, an Electone ^{™} or a similar instrument is an example of an electric musical instrument that converts electrical vibrations into tone or sound by use of oscillation circuits.

In the above embodiment, the FIR filter 146 of the audio I/O 14 is configured to have inverse characteristics of the frequency characteristics in the LPF 142 and the ADC 144. If conversion accuracy of the ADC 144 is high and the frequency characteristics at the ADC 144 can be ignored, the FIR filter 146 may be configured to have inverse characteristics of the frequency characteristics at the LPF 142 only. Similarly, in the embodiment, the FIR filter 162 of the audio I/O 16 is configured to have inverse characteristics of the frequency characteristics at the DAC 164 and the LPF 166. If the conversion accuracy of the DAC 164 is high and the frequency characteristics at the DAC 164 can be ignored, the FIR filter 162 may be configured to have inverse characteristics of the frequency characteristics at the LPF 166 only.

One or both of the FIR filters 146 and 162 may be implemented, for example, by software-based processing in the personal computer 50. That is, there is no need to provide an FIR filter 146 within the audio I/O 14, and the personal computer 50 may execute filter processing corresponding to the FIR filter 146. Specifically, the personal computer 50 may perform, on digital signals output from the ADC 144, processing corresponding to the FIR filter 146, and store the signals that have undergone the processing as a digital signal Dg1 in a storage device of the personal computer 50. In the configuration that realizes the FIR filter 146 by a software application in the personal computer 50, the storage device of the personal computer 50 may be used as the storage device M1.

Similarly, there is no need to provide an FIR filter 162 within the audio I/O 16, and the personal computer 50 may execute processing corresponding to the FIR filter 162. Specifically, the personal computer 50 may read the digital signal Dg1 from an internal storage device, perform on the read digital signal Dg1 processing corresponding to the FIR filter 162, and supply the processed signal to the DAC 164. In the configuration of realizing the FIR filter 162 as a software application in the personal computer 50, the storage device of the personal computer 50 may be used as the storage device M2. Further, a personal computer for storing or reading the digital signal Dg1 and a personal computer for executing processing corresponding to the FIR filter 146 and the FIR filter 162 may be the same or may be different.

The following aspects of the present disclosure are derivable from the foregoing description.

An impedance conversion device according to Aspect 1 of the present disclosure includes: a first input terminal configured to input a first analog signal output from an electric musical instrument; a splitter configured to split the first analog signal into a second analog signal and a third analog signal; a first output terminal configured to output the second analog signal; an impedance conversion circuit configured to convert an impedance of the third analog signal; and a second output terminal configured to output the converted third analog signal from the impedance conversion circuit. An input impedance of the impedance conversion circuit is approximately 1 GΩ or more. In the impedance conversion device according to Aspect 1, when a guitar amplifier is connected to the first output terminal, sound generated by the playing an electric musical instrument can be amplified and emitted by the guitar amplifier, while an impedance of an analog signal output from the electrical musical instrument can be converted and then output. The impedance of the first analog signal output from the electric musical instrument is not changed, and as a result, the first analog signal can be output as a second analog signal almost unchanged.

The signal processing apparatus according to Aspect 2 includes an impedance conversion device according to Aspect 1, and a first input-output device for converting the converted third analog signal output from the second output terminal into a first digital signal. The signal processing apparatus according to Aspect 2 converts an analog signal output from the electric musical instrument into a digital signal. The audio I/O 14 is an example of the first input-output device, and the audio I/O 16 is an example of the second input-output device.

In the signal processing apparatus according to Aspect 3, which is an example of Aspect 2, the first input-output device includes: an A/D converter configured to convert the converted third analog signal output from the second output terminal into the first digital signal; and a first characteristic imparter configured to impart a first characteristic to the first digital signal converted by the A/D converter. The first characteristic is an inverse characteristic of a frequency characteristic in a path from the second output terminal to an output terminal of the A/D converter. According to the signal processing apparatus according to Aspect 3, when converting an analog signal into a digital signal, it is possible to cancel frequency characteristics added at one or both of the impedance conversion circuit and the A/D converter.

In the signal processing apparatus according to Aspect 4, which is an example of Aspect 3, the frequency characteristic includes an amplitude change characteristic of a frequency and a phase change characteristic of a frequency.

The signal processing apparatus according to Aspect 5, which is an example of Aspect 3 or Aspect 4, further includes a characteristic acquirer configured to acquire the first characteristic.

In the signal processing apparatus according to Aspect 6, which is another example of Aspect 4, the first characteristic imparter includes an FIR filter.

The signal processing apparatus according to Aspect 7, which is an example of Aspect 3, further includes: a second input terminal configured to input a second digital signal; a second input-output device configured to convert the second digital signal input to the second input terminal to a fourth analog signal; a reamping device configured to convert an impedance of the fourth analog signal; and a third output terminal configured to output a fifth analog signal obtained by converting the impedance of the fourth analog signal by the reamping device.

In the signal processing apparatus according to Aspect 8, which is an example of Aspect 7, the second input-output device includes: a second characteristic imparter configured to impart a second characteristic to the digital signal input to the second input terminal; and a D/A converter configured to convert the second digital signal to which the second characteristic has been imparted to the fourth analog signal.

In the signal processing apparatus according to Aspect 9, which is an example of Aspect 8, the second characteristic is an inverse characteristic of a frequency characteristic in a path from an input terminal of the D/A converter to the third output terminal.

### Description of Reference Signs

10... signal processing apparatus, 12... impedance conversion device, 14, 16... audio I/O, 18... reamping device, 142, 166... LPF, 144... ADC, 146, 162... FIR filters, 148, 168...acquirer.

## Claims

1. An impedance conversion device comprising:
a first input terminal configured to input a first analog signal output from an electric musical instrument;
a splitter configured to split the first analog signal into a second analog signal and a third analog signal;
a first output terminal configured to output the second analog signal;
an impedance conversion circuit configured to convert an impedance of the third analog signal; and
a second output terminal configured to output the converted third analog signal from the impedance conversion circuit,
wherein an input impedance of the impedance conversion circuit is approximately 1 GΩ or more.

2. A signal processing apparatus comprising:
the impedance conversion device according to claim 1; and
a first input-output device for converting the converted third analog signal output from the second output terminal into a first digital signal.

3. The signal processing apparatus according to claim 2, wherein:
the first input-output device includes:
an A/D converter configured to convert the converted third analog signal output from the second output terminal into the first digital signal; and
a first characteristic imparter configured to impart a first characteristic to the first digital signal converted by the A/D converter, and
wherein the first characteristic is an inverse characteristic of a frequency characteristic in a path from the second output terminal to an output terminal of the A/D converter.

4. The signal processing apparatus according to claim 3,
wherein the frequency characteristic includes an amplitude change characteristic and a phase change characteristic of a frequency.

5. The signal processing apparatus according to claim 3 or claim 4, further comprising a characteristic acquirer configured to acquire the first characteristic.

6. The signal processing apparatus according to claim 4,
wherein the first characteristic imparter includes an FIR filter.

7. The signal processing apparatus according to claim 3, further comprising:
a second input terminal configured to input a second digital signal;
a second input-output device configured to convert the second digital signal input to the second input terminal to a fourth analog signal;
a reamping device configured to convert an impedance of the fourth analog signal; and
a third output terminal configured to output a fifth analog signal obtained by converting the impedance of the fourth analog signal by the reamping device.

8. The signal processing apparatus according to claim 7, wherein:
the second input-output device includes:
a second characteristic imparter configured to impart a second characteristic to the second digital signal input to the second input terminal; and
a D/A converter configured to convert the second digital signal to which the second characteristic has been imparted to the fourth analog signal.

9. The signal processing apparatus according to claim 8, wherein
the second characteristic is an inverse characteristic of a frequency characteristic in a path from an input terminal of the D/A converter to the third output terminal.
